# EUROPEAN PATENT APPLICATION

(11) **EP 4 808 307 A1**
(43) Date of publication of application: **16.09.2026**
(21) Application number: 25163893.8
(22) Date of filing: 14.03.2025
(51) Int. Cl.: H10D 48/00, H01L 21/768, H10D 64/27, B82Y 10/00

(54) **A GATE-DEFINED QUANTUM DOT DEVICE COMPRISING FERROMAGNETIC VIAS CONTACTING THE GATES**

(71) Applicant: Imec VZW, 3001 Leuven (BE)
(72) Inventor: LI, Yanan, 3001 Leuven (BE); KUBICEK, Stefan, 3212 Pellenberg (BE); GODFRIN, Clement, 1000 Brussel (BE); SIMION, George Eduard, 3271 Scherpenheuvel-Zichem (BE); LI, Ruoyu, 3000 Leuven (BE); DE GREVE, Kristiaan, 3001 Heverlee (BE); WAN, Danny, 3000 Leuven (BE)
(74) Representative: Patent Department IMEC

(57) **Abstract**

In a quantum dot device according to the invention, a plurality of gates (1,2) is provided on a gate dielectric layer (4) formed on a semiconductor substrate (3) configured to confine qubits in well-defined quantum dots. Via connections (10,18) which are directly contacting the gates include at least one or more via connections formed of an electrically conductive ferromagnetic material, whereas the via connections which are contacting the remaining gates are not formed of a ferromagnetic material. Also, the material of the gates (1,2) is electrically conductive but not ferromagnetic. The invention thereby enables addressing and controlling individual qubits associated to gates contacted by ferromagnetic via connections (10) which are configured to act as permanent magnets in the operative quantum dot device.

## Description

### Field of the Invention

The present invention is related to a quantum dot device applicable in a quantum computing processor.

### State of the art.

Quantum dot devices on semiconductor material have been explored extensively in recent years, as one of the main avenues towards realizing a workable quantum computing chip. Various architectures have been explored, which all have in common the presence of closely spaced gates configured so that quantum dots are defined underneath one or more of these gates. The gates may for example be metal gates formed on a thin layer of silicon oxide lying on a silicon substrate. By applying appropriate voltages to the gates, it is possible to create quantum dots underneath the gates, i.e. small well-defined electron or hole islands, and to manipulate qubits associated with the quantum dots. The qubits are defined by the spin state of individual electrons of the quantum dots, while magnetic resonance can be used to control the spin states.

The qubits are placed in a strong external magnetic field that creates a shift between the energy of the 'spin-up' and 'spin-down' states of the qubits. By applying an electromagnetic pulse at or near the resonance frequency of the qubit, coherent manipulation of qubits is realized. However, in order to address individual qubits in a qubit array, qubits must have different energy shifts between the spin states.

This individual addressability has been realized by placing small local magnets in the vicinity of the qubits, so that the energy shift is determined by the sum of the external field and a local field generated by the local magnets. An example of this approach is shown in patent publication document EP3967650, wherein nanomagnets are positioned above selected quantum dots and distanced from control gates associated to said selected quantum dots. However, this and other presently known configurations of micromagnets or nanomagnets are not compatible with dense 2D qubit architectures which are currently being developed.

### Summary of the invention

The invention is related to a quantum dot device and to methods of fabrication thereof, in accordance with the appended claims. In a quantum dot device according to the invention, a plurality of gates is provided on a gate dielectric layer formed on a semiconductor substrate configured to confine qubits in well-defined quantum dots. Via connections which are contacting the gates (i.e. in physical contact with the gates) include at least one or more via connections formed of an electrically conductive ferromagnetic material, whereas the via connections which are contacting the remaining gates are not formed of a ferromagnetic material. Also, the material of the gates is electrically conductive but not ferromagnetic.

The invention thereby enables addressing and controlling individual qubits associated to gates contacted by ferromagnetic via connections which are configured to act as permanent magnets in the quantum dot device when the device is operational. The device is operational when qubits are effectively confined to one or more of the quantum dots. The device may be operational according to various operational modes, such as ESR (Electron Spin Resonance) and EDSR (Electron Dipole Spin Resonance). The use of via connections both for electrically contacting gates of the device and for realizing nanomagnets enables the incorporation of said magnets in a dense 2D gate array configuration. The invention is however applicable to any gate configuration, including 1D configurations.

The invention is in particular related to a quantum dot device comprising a semiconductor substrate configured to confine qubits in a plurality of quantum dots, a dielectric layer on the semiconductor substrate, and a plurality of gates on the dielectric layer, the device further comprising an interconnect structure for contacting the gates, the interconnect structure comprising via connections above and in contact with respective gates, the via connections being formed of electrically conductive material,
wherein:
- the gates are formed of an electrically conductive material that is not ferromagnetic,
- at least one or more of the via connections are formed of an electrically conductive ferromagnetic material and are configured to act as permanent magnets when the device is operational.
According to an embodiment, the gates form a 2-dimensional gate array. According to an embodiment, said ferromagnetic material is cobalt.

According to an embodiment, the gates comprise plunger gates and barrier gates and wherein the via connections formed of ferromagnetic material are in contact with at least one or more of the plunger gates, while all via connections to the barrier gates are formed of non-ferromagnetic material.

According to an embodiment, the via connections formed of a ferromagnetic material are configured to induce a magnetic field gradient.

The invention is also related to a method for producing a quantum dot device according to any one of the preceding claims, the method comprising the steps of :
- producing said dielectric layer on the semiconductor substrate (3) and producing said gates on the dielectric layer by lithography and etching techniques,
- producing an interlayer dielectric, IDL, layer on the gates and planarizing said IDL layer,
- producing first via openings in the IDL layer which expose one or more first gates at the bottom of the first via openings,
- filling the first via openings with a first electrically conductive material,
- producing second via openings in the IDL layer which expose one or more second gates at the bottom of the second via openings,
- filling the second via openings with a second electrically conductive material,
wherein one of the first and second electrically conductive materials is a ferromagnetic material, and the other is a non-ferromagnetic material.

According to an embodiment of the method, the gates form a 2-dimensional gate array.

According to an embodiment of the method, said ferromagnetic material is cobalt.

According to an embodiment of the method, the gates comprise plunger gates and barrier gates and wherein the via connections formed of ferromagnetic material are in contact with at least one or more of the plunger gates, while all via connections to the barrier gates are formed of non-ferromagnetic material.

According to an embodiment of the method, the via connections formed of a ferromagnetic material are configured to induce a magnetic field gradient.

### Brief description of the figures

Figure 1 is a 3D view of an exemplary 2-dimensional gate architecture of a quantum dot device according to an embodiment of the invention.
Figures 2 to 9 illustrate process steps of a method for producing a quantum dot device according to an embodiment of the invention, starting from the gate architecture shown in Figure 1.

### Detailed description of embodiments of the invention

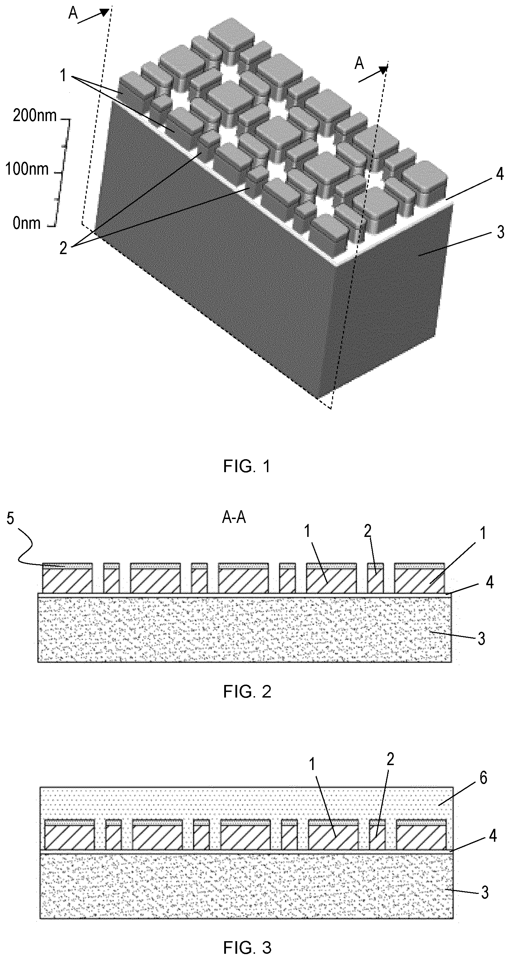

The 2D gate architecture illustrated in Figure 1 comprises gates 1,2 which have been produced on a semiconductor substrate 3. The plane AA in Figure 1 is a section plane through one row of gates 1,2. A frontal view of this section plane is shown in Figure 2. The substrate 3 may be any substrate suitable for the confinement of qubits in a plurality of quantum dots in the substrate beneath the substrate's upper surface, for example inside an isotropically purified silicon layer that forms an upper layer of the substrate, or between layers of a layer stack that constitutes an upper portion of the substrate. The gates 1,2 are formed on a dielectric layer 4, for example a layer of SiO₂, which will serve as the gate dielectric when the gates are operative. The gates are formed of a material that is electrically conductive but that is not ferromagnetic. Suitable gate materials include polysilicon or TiN for example. The scale included in the Figure 1 gives an indication of applicable dimensions of the gates. The invention is however not limited to the represented dimensions of the gates nor to the exact layout of the illustrated configuration.

Two types of gates are shown in the drawings. In the finished device, the larger gates 1 serve as plunger gates for confinement of qubits under these gates, while the narrower gates 2 surrounding each plunger gate serve as barrier gates, for regulating tunnel coupling between quantum dots or between a quantum dot and a reservoir. As known to the skilled reader, said reservoirs may be implemented around the gate array. The reservoirs are not represented in the drawings.

A hardmask layer 5 may be present on the gates in this example, which is a consequence of the process sequence applied for producing the gates, which includes standard lithography and etching steps. The hardmask 5 may remain on the gates 1,2 in the subsequent process steps described hereafter, or alternatively it may be removed before executing said process steps. The hardmask may be formed of any suitable material, for example silicon nitride.

Process steps described hereafter are configured to produce via connections for contacting the gates 1,2. According to the illustrated embodiment, this is done in two stages, a first stage wherein ferromagnetic via connections are produced to at least one or more of the plunger gates 1, and a second stage wherein non-ferromagnetic via connections are produced to the remaining plunger gates 1 and to the barrier gates 2.

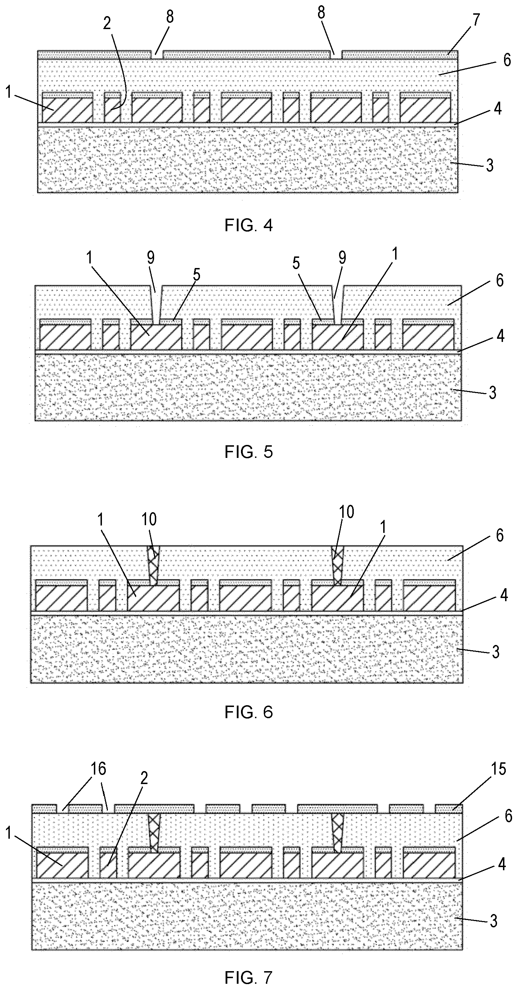

With reference to Figure 3, a layer 6 of interlayer dielectric (IDL) material, for example SiO₂, is deposited on the topography defined by the gates, embedding the gates in said IDL material. The IDL layer 6 is planarized and a hardmask layer 7 is produced on the planarized IDL layer as shown in Figure 4. As also shown in Figure 4, hardmask layer 7 is patterned by lithography and etching, creating openings 8 in the hardmask layer, said openings being positioned above a number of the plunger gates 1 of the gate configuration. In the example shown, two openings 8 are formed above the row of gates shown in the cross-section. However in other rows of the 2D gate configuration, a higher or lower number of openings, or possibly no openings could be defined, depending on the quantum dot configuration of the device (see further).

The openings 8 are transferred by etching to the IDL layer 6 and the hardmask portions 5 above some of the plunger gates 1, as illustrated in Figure 5, creating via openings 9 above selected plunger gates, i.e. the upper surface of the selected plunger gates 1 is exposed at the bottom of the via openings 9. Possibly the hardmask layer 7 is consumed at the end of this etch process, or said hardmask layer is stripped by an additional removal step.

With reference to Figure 6, the via openings 9 are thereafter filled with a ferromagnetic material. This may be cobalt (Co) or any other ferromagnetic material such as Fe or Ni. This may be done by physical vapour deposition for example. Figure 6 shows the result after filling the via openings and after planarization of the IDL layer 6 so that ferromagnetic via connections 10 are formed having an upper surface at the same level as the upper surface of the IDL layer 6.

Thereafter (as seen in Figure 7), a second hardmask layer 15 is produced and patterned according to a second pattern of openings 16, positioned above the remaining plunger gates 1 and the barrier gates 2.

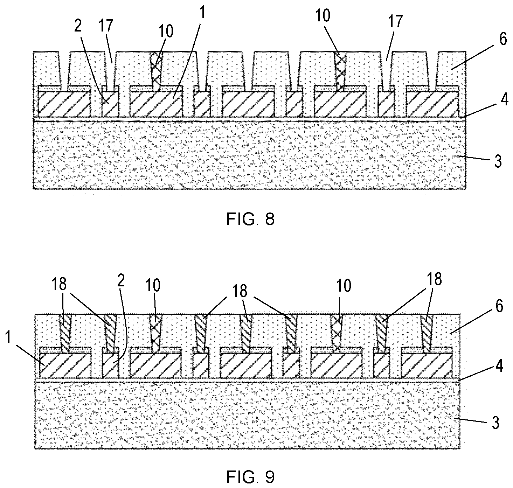

The second pattern of openings 16 is transferred by etching to the IDL layer 6, as shown in Figure 8, to create a second group of via openings 17, which are thereafter filled with a non-ferromagnetic material, for example W or Ru. This is followed again by planarizing the IDL layer 6, as shown in Figure 9, thereby obtaining non-ferromagnetic via connections 18 and ferromagnetic via connections 10 having an upper surface at the same level as the upper surface of the IDL layer 6.

The ferromagnetic via connections 10 act as permanent nanomagnets, either directly upon deposition of the ferromagnetic material in the via openings 9, or after being placed in an external magnetic field of sufficient strength to permanently magnetize the via connections 10. In operation, the via connections are placed in such a field, hence the ferromagnetic via connections 10 are magnetized by said field and thereafter behave as permanent magnets. The ferromagnetic via connections 10 have the double function of conducting electric current to a number of the plunger gates 1 and of acting as nanomagnets in the vicinity of said gates, while the remaining via connections 18 have only the electrical function and not the magnetic function.

The gates 1,2 are not formed of ferromagnetic material in a device according to the invention. Hence, the only contribution to addressability of individual gates comes from the nanomagnets formed by the ferromagnetic via connections.

Starting from the state shown in Figure 9, additional process steps may be performed for creating consecutive levels of conductors and via connections which can be done by standard Back End Of Line (BEOL) processing steps known as such.

The order in which the ferromagnetic and non-ferromagnetic via connections are produced is not necessarily as described above, i.e. first producing the ferromagnetic via connections 10 and then the non-ferromagnetic via connections 18. It is also possible to first produce the non-ferromagnetic via connections 18 and thereafter the ferromagnetic via connections 10.

The ferromagnetic via connections 10 enable addressability of individual qubits by modulating the energy shift between the spin up and spin down energy states of a qubit that is confined to a quantum dot associated with a gate contacted by a ferromagnetic via connection. The ferromagnetic via connections may furthermore be configured to induce a magnetic field gradient in the vicinity of said ferromagnetic via connections. These functionalities may be the same as in prior art configurations wherein nanomagnets are incorporated in a quantum dot device. Dimensions of the ferromagnetic via connections 10 may be in accordance with required dimensions enabling said functionalities. A difference between the invention and known configurations is the fact that according to the invention, nanomagnets are integrated in the interconnect structure for contacting the gates, namely as via connections coupled to at least one or more of the gates, whereas in known configurations nanomagnets or micromagnets are not a part of said interconnect structure. The double function of the nanomagnets (permanent magnet and electrical conductor) enables the incorporation of these magnets in a dense architecture which would be difficult or impossible using prior art magnet arrangements. The invention is however not limited to 2D gate arrays but is also applicable to 1D gate arrays, and even to non-array layouts.

Any quantum dot device configuration that is known in the art can be realized in a device according to the invention. The configuration may for example depend on the operational mode applied for controlling the qubits. Known operational modes include ESR (Electron Spin Resonance) or EDSR (Electron Dipole Spin Resonance).

The way in which these configurations are implemented in terms of where the nanomagnets are to be placed in the device is not necessarily different in a device according to the invention compared to known devices, so any known configuration can be applied in a device according to the invention, including for example the configurations described in EP3967650. The way in which the nanomagnets are realized is different, namely in the form of electrically conductive via connections which contact selected gates.

Parts of a quantum dot device which are not described explicitly hereabove may be in accordance with known quantum dot configurations.

## Claims

1. A quantum dot device comprising a semiconductor substrate (3) configured to confine qubits in a plurality of quantum dots, a dielectric layer (4) on the semiconductor substrate, and a plurality of gates (1,2) on the dielectric layer, the device further comprising an interconnect structure for contacting the gates, the interconnect structure comprising via connections (10,18) above and in contact with respective gates, the via connections being formed of electrically conductive material,
wherein:
- the gates (1,2) are formed of an electrically conductive material that is not ferromagnetic,
- at least one or more of the via connections (10) are formed of an electrically conductive ferromagnetic material and are configured to act as permanent magnets when the device is operational.

2. The device according to claim 1, wherein the gates (1,2) form a 2-dimensional gate array.

3. The device according to claim 1 or 2, wherein said ferromagnetic material is cobalt.

4. The device according to any one of the preceding claims, wherein the gates comprise plunger gates (1) and barrier gates (2) and wherein the via connections (10) formed of ferromagnetic material are in contact with at least one or more of the plunger gates (1), while all via connections (18) to the barrier gates (2) are formed of non-ferromagnetic material.

5. The device according to any one of the preceding claims, wherein the via connections (10) formed of a ferromagnetic material are configured to induce a magnetic field gradient.

6. A method for producing a quantum dot device according to any one of the preceding claims, the method comprising the steps of :
- producing said dielectric layer (4) on the semiconductor substrate (3) and producing said gates (1,2) on the dielectric layer by lithography and etching techniques,
- producing an interlayer dielectric, IDL, layer (6) on the gates (1,2) and planarizing said IDL layer,
- producing first via openings (9) in the IDL layer (6) which expose one or more first gates at the bottom of the first via openings,
- filling the first via openings with a first electrically conductive material,
- producing second via openings in the IDL layer (6) which expose one or more second gates at the bottom of the second via openings,
- filling the second via openings with a second electrically conductive material,
wherein one of the first and second electrically conductive materials is a ferromagnetic material, and the other is a non-ferromagnetic material.

7. The method according to claim 6, wherein the gates (1,2) form a 2-dimensional gate array.

8. The method according to claim 6 or 7, wherein said ferromagnetic material is cobalt.

9. The method according to any one of claims 6 to 8, wherein the gates comprise plunger gates (1) and barrier gates (2) and wherein the via connections (10) formed of ferromagnetic material are in contact with at least one or more of the plunger gates (1), while all via connections (18) to the barrier gates (2) are formed of non-ferromagnetic material.

10. The method according to any one of the claims 6 to 9, wherein the via connections (10) formed of a ferromagnetic material are configured to induce a magnetic field gradient.
